(19) Europäisches Patentamt
European Patent Office
Office européen des brevets

(11) **EP 2 012 243 B1**

(12) **EUROPEAN PATENT SPECIFICATION**

(45) Date of publication and mention
of the grant of the patent:
**23.01.2019 Bulletin 2019/04**

(51) Int Cl.:
**G06F 17/50** (2006.01)    *F01D 5/14* (2006.01)

(21) Application number: **07111858.2**

(22) Date of filing: **05.07.2007**

(54) **Aerodynamic design optimization using knowledge extraction from analyzing unstructured surface meshes**

Optimierung des aerodynamischen Designs mittels aus der Analyse unstrukturierter Oberflächengewebe gewonnener Kenntnisse

Optimisation de la conception aérodynamique utilisant l'extraction de connaissances de l'analyse de grilles de surface non structurées

(84) Designated Contracting States:
**DE FR GB**

(43) Date of publication of application:
**07.01.2009 Bulletin 2009/02**

(73) Proprietor: **Honda Research Institute Europe GmbH**
**63073 Offenbach/Main (DE)**

(72) Inventors:
• **Gräning, Lars**
**99423 Weimar (DE)**
• **Olhofer, Markus**
**63500 Seligenstadt (DE)**
• **Sendhoff, Bernhard**
**63486 Bruchköbel (DE)**

(74) Representative: **Rupp, Christian**
**Mitscherlich PartmbB**
**Patent- und Rechtsanwälte**
**Sonnenstraße 33**
**80331 München (DE)**

(56) References cited:
**EP-A- 1 486 893      WO-A-03/021498**
**US-A1- 2005 159 936**

• **TIMOTHY W. SIMPSON, JESSE D. PEPLINSKI, PATRICK N. KOCH, AND JANET K. ALLEN: "ON THE USE OF STATISTICS IN DESIGN AND THE IMPLICATIONS FOR DETERMINISTIC COMPUTER EXPERIMENTS" PROCEEDINGS OF DECT'97, 14 September 1997 (1997-09-14), - 17 September 2007 (2007-09-17) pages 1-14, XP002465753**

**Description**

This invention finds application in the field of 3D aerodynamic design optimization where often a huge amount of geometric data is produced during the development of new outperforming designs. (The geometric data are then translated in real-world aerodynamic hardware designs). In general only the most promising results with respect to one or more performance measures are considered for further investigations.

If different optimization cycles of an iterative optimization algorithm have been performed, where different representations have been used, it is difficult to find an adequate shape representation which captures the whole manifold of the generated designs and can be applied to data mining techniques like SOMs (Self Organizing Maps).

Each optimization cycle might be a manual or a computational optimization process and might have different design parameters. The unstructured surface mesh as a general shape representation allows the analysis of local design modifications and their influence on the performance value.

Patent Application Publication EP 1 486 893 A2 discloses a method for optimizing the design of a component by conducting at least one analysis employing a 3D computer model which incorporates empirically obtained data values stored as 2D data sets. Ambiguities between values from different data sets which relate to common nodes, wherein the nodes define polygonal elements common to both 2D data sets, are resolved by determining an apparent area of the common polygonal elements from each of the at least two 2D datasets. The data value from the 2D data set associated with the common polygonal element having the greater apparent area is used. An optimum component design is selected on the basis of the results of the analysis.

Patent Application Publication US 2005/0159936 A1 shows a method for optimizing the design of a component, in which a set of principle design variants is generated. The design variants have design parameters, which are common to all the sign variants of the set of principle design variants. Some of the design parameters differ between variants. Subsets of secondary design variants are generated by a computer executed rule based geometry engine, wherein the subsets of secondary design variants comprise at least one secondary design variant, generated by modifying at least one design parameter or design variable of the principal design variant.

It is the object of the present invention to make more efficient the optimization of real-world structures, such as e.g. aerodynamic bodies (turbine blades etc.).

This object is achieved by means of the features of the independent claims. The dependent claims develop further the central idea of the invention.

Generally it is the idea of the invention to extract knowledge also from designs which are not considered as the most promising during an optimization run (cycle), and to use this knowledge as a guidance for the further optimization, making the optimization thus more efficient.

A first aspect of the invention relates to a computer-implemented method for analysing data representing the optimization of real-world designs according to at least one criterion, expressed in physical entities. The method targets at finding the areas of the design which are particularly sensitive to changes. Thereby

- different modifications of the design are provided,
- the design data are represented by unstructured triangular surface meshes,
- a displacement measure for computing local differences between corresponding points of two different modifications of the data is calculated,
  [LD1]- the performance difference, expressed by the at least one criterion, between the at least two design modifications is calculated, and
- a sensitivity information (e.g. a signal) is output representing the interrelation between the displacement measure and the performance differences.

A linear or non-linear interrelation can be represented by the output sensitivity information.

The output sensitivity information can be e.g. correlation coefficient or a mutual information.

The output sensitivity information signal can indicate which regions of the design influence the performance.

Interrelations between design regions can be calculated by means of rule induction from decision trees or other modelling techniques.

A further aspect of the invention relates to a method for the optimization of data representing real-world designs according to at least one criterion, especially aerodynamic bodies. The method comprising the steps of:

- generating a sensitivity information, preferably using a method as set forth above, the sensitivity information indication the impact of design changes at a defined area of the design on the performance of the design, the performance being expressed in at least one physical entity,
- setting initial design parameters depending on the sensitivity information signal,
- running an optimization algorithm, such as e.g. an evolutionary optimization, starting from the initial design until a stop criterion has been reached, and

- outputting data representing an optimized real-world design.

The position of spline control points can be set depending on the sensitivity information and on information about already performed design modifications.

Strategy parameters, e.g. global or individual step size can be set depending on the sensitivity information signal and the rule set which captures information on the relation between distant design regions.

A still further aspect of the invention relates to a method for generating a meta model, such as e.g. a neural network, for computing, in terms of physical entities the fitness of data representing real-world designs, the method comprising the steps of:

- generating a sensitivity information, the sensitivity information indication the impact of design changes at a defined area of the design on the performance of the design, the performance being expressed in at least one physical entity,
- setting up the meta model as unstructured surface meshes, and
- adapting the number of parameters for training the meta model using the sensitivity information.

A still further aspect of the invention relates to a computer program product, implementing a method as set forth above when run on a computing device.

In the following the invention will be explained referring to the enclosed list of equations and the figures of the enclosed drawings.

Figure 1 shows an illustration of a triangulated surface mesh,

Figure 2 shows case studies for displacement measures,

Figure 3 illustrates an error vector,

Figure 4 illustrates a triangular mesh defining the surface of a 3D turbine blade,

Figure 5 illustrates the means value of a set of turbine blades,

Figure 6 shows the relative correlation value is calculated for each vertex of the 3D turbine blade. The values are mapped onto the surface of the blade.

Figure 7 illustrates filtered points which probably have no influence to the performance and vertices are pointed out which are either overall positive correlated or overall negative correlated.

Figure 8 illustrates a of short version of a decision tree generated from the 3D turbine blade data set. Only the sign of the displacement measure of a pre-selected set of vertices is used as input.

Figure 9 illustrates of the integration of the knowledge extraction steps into the manual design optimization process.

Figure 10 illustrates Integration of knowledge extraction from existing design data for setting initial design and strategy parameters.

Figure 11 illustrates Integration of the surrogate model into the optimization algorithm. Unstructured surface meshes are used as a general representation for training the surrogate model. Knowledge extraction from design data is used to reduce the number of parameters for model training.

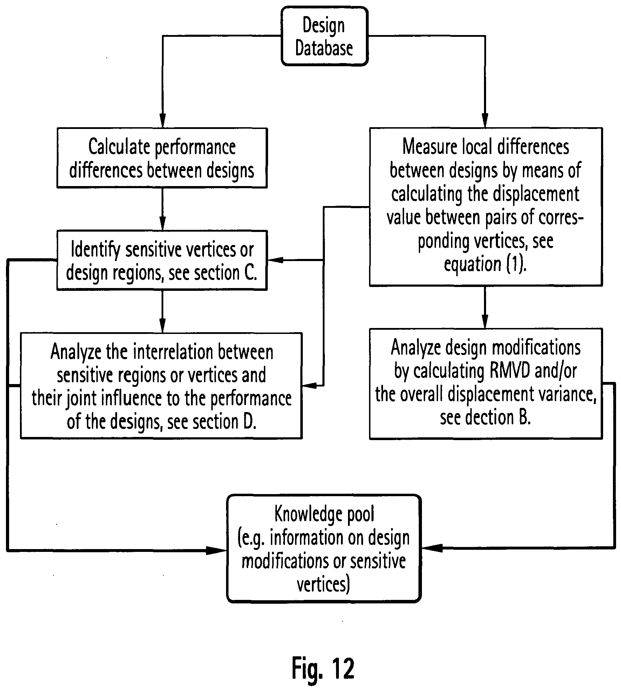

Figure 12 shows a flowchart of the processing of information in an optimization.

The invention targets at an enhancement of the effectiveness of the computer-implemented optimization of data representing real-word designs. The optimization is carried out in order to improve the performance of the design, wherein the performance can be expressed in on or more physical measures.

Cyclic optimization methods produce at least one modification of the design per cycle. The design modifications can also stem from different runs or even from different optimization algorithms. The invention proposes displacement measure to measure local design modifications between surface meshes. The combination of the displacement measure with well known techniques from statistics and data mining allows the extraction of useful information from the design database for supporting further optimizations. The information thus gained e.g. indicates the location-dependent performance sensitivity of the design to changes.

A typical application is the field of optimizing aerodynamic bodies. The invention suggests basic techniques not for generating 3D designs rather for measuring displacement and analyzing the interrelation of the displacement to specific performance criteria.

SURFACE REPRESENTATION

For the optimization of the shape of 3D unstructured triangular surface meshes are suggested as a general representation to describe the surface of each design. Most shape representations can be converted to unstructured surface meshes.

For the description of the surface meshes the mathematical framework of Marc Alexa, Recent Advances in Mesh Morphing, Computer Graphics forum,, vol. 21,no. 2, pp. 173-197, 2002 can be used. It is assumed that the shape of a 3D design is described using a polygonal surface mesh M which is a partial linear approximation of the contour of the design. It is postulated that each mesh M consists of a list of vertices V, a complex K and a list of normal vectors N. The vertex list $V = (\vec{v}_1,...,\vec{v}_n)^T$ describes the geometric position of the vertices in $R^d$. In this work this is restricted to d = 3 and $\vec{v}_i = (x_1,x_2,x_3)^T$.

A vertex can be seen as a sample point of the contour of the design. Each face of the polygonal surface mesh is defined by simplices of the form $\{i_1,i_2,i_3,...,i_m\}$ where $i_l, l \in [1..n]$ are indices pointing to vertices which enclose the polygonal face.

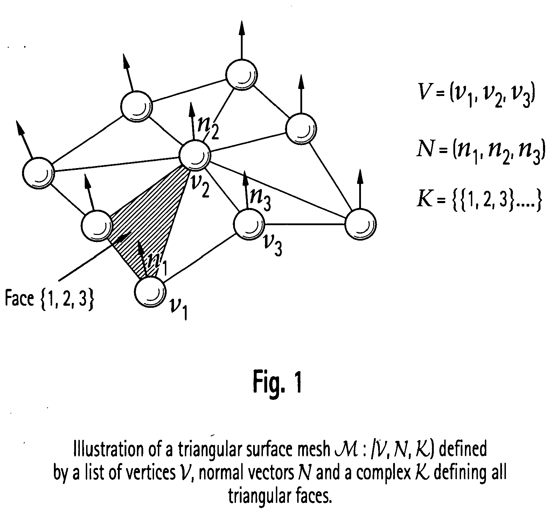

Fig. 1 should illustrate a triangulated surface mesh where the number of vertices m which are used to form one polygon is set to m = 3. Additionally to the vertex list a list of normal vectors $N = (\vec{n}_1,...,\vec{n}_n)$ is given. The normal vector provides information on the curvature of the surface at the position of vertex $\vec{v}_i$.

DISPLACEMENT MEASUREMENT

Facing the task of tracking local design modifications between two surfaces means measuring the displacement of one sample point on the surface of the first geometry to a point on the surface of the second geometry. In general a sample point can be any point on the surface of the geometry.

Under the assumption that the surface triangulation results in surface meshes where the location and the number of vertices is sufficient to capture most characteristic changes of all designs at hand, the measurement of the displacement between corresponding sample points can be reduced to the measurement of the displacement between corresponding vertices. To measure the displacement between corresponding vertices first one has to identify corresponding vertices and has to find a proper metrics for measuring the amount and the direction of the displacement.

Finding an appropriate algorithm for the identification of corresponding points should not be considered here. It is assumed that for each vertex on one design a corresponding vertex or at least an good estimation of the corresponding vertex on the remaining designs exists.

Definition of the displacement:

Given two unstructured surface meshes and all corresponding vertices we define local deformation as the displacement of one vertex of the first mesh to the location of the corresponding vertex of the second mesh. One way

$$\vec{s}_{ij} = \vec{v}_i^I - \vec{v}_j^m$$

to capture the displacement is to use the difference vector which is the difference between vertex i of mesh 1 and vertex j of mesh m. The advantage of using the difference vector is that the vector clearly captures the correct displacement in the three dimensional space between both vertices. But there exist some disadvantages which make the difference vector not useful for the analysis of local deformations between designs. One disadvantage is that the difference vector is sensitive to errors which are done by the estimation of corresponding points and to different sampling of the surface of the geometries. Another disadvantage is that using the difference vector needs d = 3 parameters for describing the displacement of one vertex. In order to capture the displacement between two complete surface meshes the number of parameters is 3 · n where n equals the number of vertices. It has to be considered that a higher number of parameters for describing the displacement makes following analysis and knowledge extraction much harder.

In order to get rid of the problems by using the difference vector the displacement measure according to equation (1) is proposed for measuring the amount and the direction of vertex modifications. The displacement measure is defined as the projection of the difference

$$\vec{s}_{ij} = \left( \vec{v}_i^l - \vec{v}_j^m \right)$$

onto the normal vector $\vec{n}_i$ of vertex $\vec{v}_i$ of a given reference design 1. The absolute value of the displacement measure provides information on the amount while the sign of the displacement measure in conjunction with the normal vector of the vertex provides information on the direction of vertex modification. The normal vector describes a tangential plane through the vertex points towards the normal or positive direction of vertex deformation.

Major Properties:

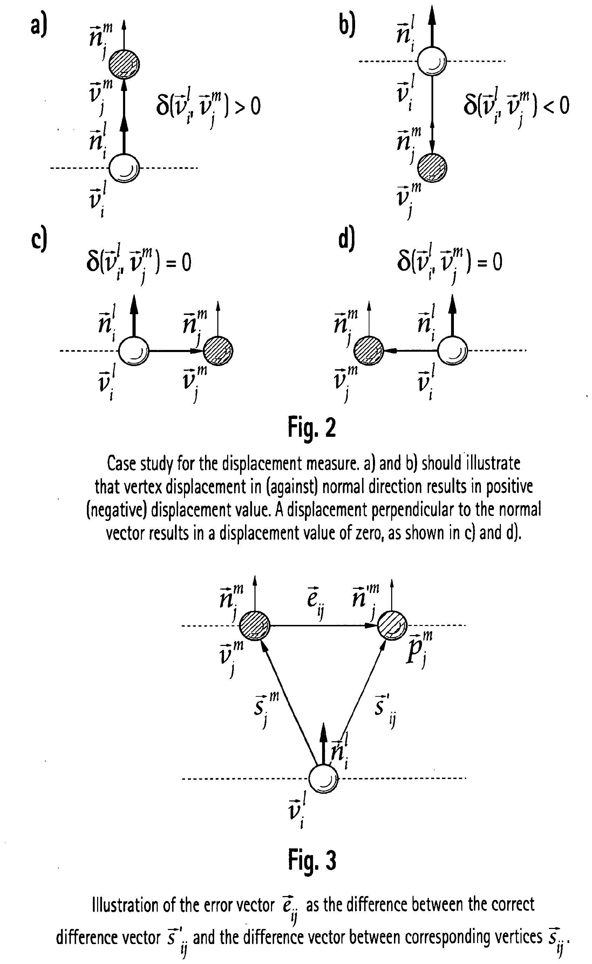

By definition the displacement measure describes the position of a vertex in reference to a previous position.
Furthermore the displacement measure is a vector quantity containing both the magnitude and the direction of vertex modification. Fig. 2 illustrates some interesting characteristic properties of the displacement measure. Assume two corresponding $\vec{v}_i^l$ and $\vec{v}_j^m$, where $\vec{v}_i^l$ belongs to the mesh of the reference geometry 1 and $\vec{v}_j^m$ belongs to the deformed surface mesh m. If a vertex $\vec{v}_i^l$ has been moved into the positive direction of the normal vector and hence $\vec{v}_j^m$ is located above the tangential plane described by the normal vector, then the displacement value is positive, see Fig. 2a). If the deformed vertex $\vec{v}_j^m$ is below the plane described by the normal vector, the displacement value is always negative, as illustrated in Fig. 2b). And finally when $\vec{v}_j^m$ is located within the tangential plane of the normal vector, then the amount of the displacement measure equals zero, see Fig. 2c) and d). If $\vec{v}_i^l$ has been deformed exactly along the normal vector, then the displacement measure equals the signed length of the difference vector

$$\vec{s}_{ij} = \vec{v}_i^l - \vec{v}_j^m$$ what again equals the Euclidean distance between corresponding vertices.

Corresponding vertices might arise an error in the displacement measure as illustrated in Fig. 3 and written more formal in equation (3), where $\vec{e}_{ij}$ describes the error between the ideal displacement value and the measured displacement value. The difference vector between the correct matching corresponding point $p_j^m$, and vertex $v_i^l$ is defined as $\vec{s}_{ij}$ while the difference vector between $\vec{v}_i^l$ and $\vec{v}_j^m$ is $\vec{s}_{ij}$. The ideal difference vector can be written as $\vec{s}_{ij} = \vec{s}_{ij} + \vec{e}_{ij}$ and hence the displacement for the ideal difference vector is defined as in equation 3. Under the assumption that the curvature of both surfaces 1 and m is similar at the position of the corresponding vertices it follows that

$$\vec{n}_i^l \approx \vec{n}_j^m$$ . Then the error term from equation (3) can be rewritten as shown in equation (4).

If additionally a smooth surface or an small error $|\vec{e}_{ij}|$ is assumed, $\vec{e}_{ij}$ is perpendicular to $\vec{n}_j^m$ and hence

$$cos(\angle(\vec{e}_{ij}, \vec{n}_j^m)) \approx 0,$$ so the error term becomes zero too. From that it can be reasoned that the displacement measure is less sensitive to small errors coming from surface triangulation or from the estimation of corresponding points.
Another advantage of using the displacement measure compared with the difference vector is that only n parameters are required for the description of the differences between two unstructured surface meshes.

KNOWLEDGE EXTRACTION FROM DESIGN DATA

In aerodynamic design optimization the main goal is to find 3D shapes (to be implemented as real-world bodies) which are optimal for specific physical performance measures like aerodynamic drag, lift or pressure loss with respect to certain constraints (e.g. manufacturing limitations). The optimization of aerodynamic designs is often an iterative process where designs are generated, the performance of each design is determined and a low number of outperforming designs is used as basis for further design modifications. Such design optimization process always produces a big amount of data and mostly just a small amount of information covered by the complete data set is used for developing new designs.

The invention proposes to use the displacement measure in conjunction with statistical and data mining methods in order to gain meaningful information from the design data set at hand, which information can be output and processed e.g. to guide the course of the optimization. The property of the displacement measure that it is a scalar value allows the calculation of statistical methods like mean, median, correlation coefficient or others. Using the difference vector instead of the displacement measure would make it quite complicated to apply these formulas and methods and using distance based measures like the Euclidean distance the information on the direction of the displacement gets lost.

Applying the invention to the optimization of 3D Turbine Blades:

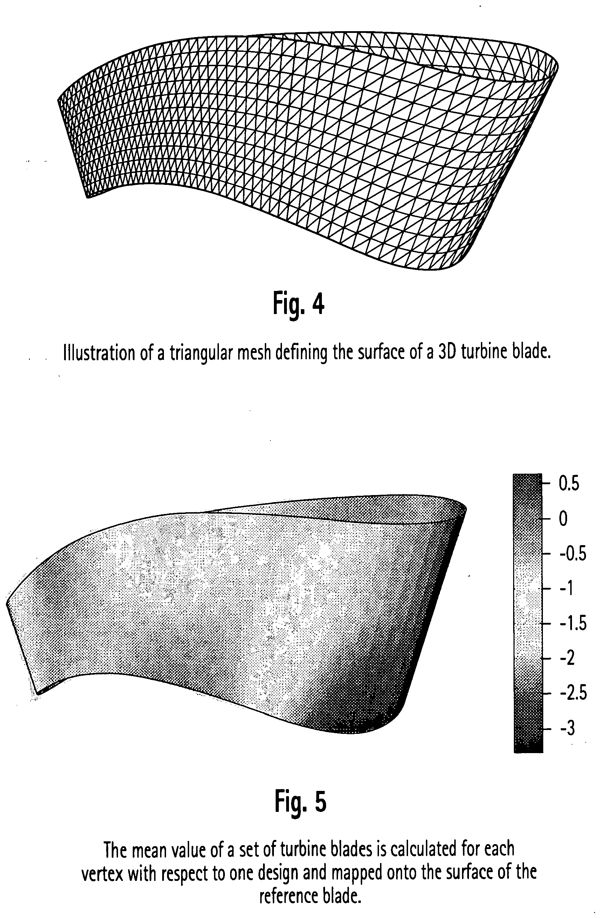

To demonstrate the applicability of the following methods to data from real world optimization problems all methods are applied to the turbine blade data set. The data set consists of unstructured surface meshes shaping the surface of a three dimensional gas turbine stator blade. Each mesh consists of sample points equally distributed at the surface of the blade. The designs are chosen from a larger set of blade designs which are the result of several computational design optimization runs. For the optimization the blade has been represented by two B-spline surfaces which shape the so called hub and the tip section of the blade. Each section is defined by parameters which code the control points of the splines. The complete 3D blade design is then the result of a linear interpolation between both sections. Based on the spline representation the unstructured surface mesh has been generated by sampling the contour of the spline surfaces. Afterwards quadrangular faces are generated by connecting corresponding sample points. Finally the resulting faces are triangulated and refined as can be seen in Fig. 4.

The triangulation has been performed in a way that the normal vectors of the triangular faces and the normal vector of the vertices points towards the outside of the blade. No triangulation of the hub and tip section has been performed because the flow is only simulated around the side-wall of the blade. For the simulation of the flow an in-house Navier stokes flow solver HSTAR3D has been used. Based on the simulated flow the average pressure loss of the blade has been calculated and determines the performance of the blade. For further details on the turbine blade optimization itself the reader is refered to Martina Hasenj"ager, Bernhard Sendhoff, Toyotaka Sonoda and Toshiyuki Arima, "Three dimensional aerodynamic optimization for an ultra-low aspect ratio transonic turbine stator blade", Proceedings of the ASME Turbo Expo, ASME Paper No. GT2005-68680, 2005.

Displacement Analysis

Analyzing local modifications in form of vertex displacement helps to get some insights into the exploration of the design space. Two measures are suggested: the relative mean vertex displacement which provides information on how a vertex has been modified based on one reference design and the overall displacement variance which highlights the vertices which frequently have been modified.

1) Relative Mean Vertex Displacement:

In order to get information on local design modifications concerning the whole data set and relating to one reference design we define the relative mean vertex displacement (RMVD) as formalized in equation (5). Given a data set of N unstructured surface meshes the RMVD calculates the mean displacement of vertex i of a predefined reference mesh r to each corresponding vertices j of the remaining meshes. Using the RMVD in conjunction with the suggested displacement measure one is able to extract information on the mean amount and direction of modification of a vertex located at the surface of the reference design based on the whole design data set. If the displacement value averages to a positive value indicates that the vertex has been modified towards the normal vector of the vertex. A negative value of indicates a modification against the normal direction of the vertex. If the RMVD value is zero means that the vertex hasn't been modified or the modifications which have been performed are equally weighted around the reference vertex.

If outliers exist which strongly influence the calculation of the RMVD it is strongly suggested to use a combination of the displacement measure with the statistical median to retrieve the desired information. As an example the RMVD value has been calculated for the blade data set choosing one as reference design, which is shown in Fig. 4. The chosen reference design was one of the first initial blade designs before starting some optimization.

The calculated RMVD values are encoded to corresponding grey code values and have been mapped onto the surface mesh of the reference blade as shown in Fig. 5. Dark blue indicates modifications against the direction of the normal vector while dark red values identify modifications with the direction of the normal vector. Each normal vector of the vertices points to the outside of the blade. Calculating the RMVD provides an useful overview on the design modifications which have been performed with respect to one reference design. In the presented example it can be seen that the blade in general has become more thinner during the optimization process, because we chosen one of the first blades as reference design.

2) Overall Displacement Variance:

For calculating the RMVD value a reference design is necessarily needed. If the mean displacement for all possible design combinations is calculated, as in equation (6), and again assuming that the normal vectors of the corresponding vertices are similar, the mean displacement value will always be around. The reason is that if both normal vectors are similar, calculating the displacement of vertex i of design r to the corresponding vertex j of design m is about minus the displacement of vertex j to vertex i,. Hence the overall mean doesn't provide useful information on the design data set.

In order to get an overview on the variation of local design modifications the overall displacement variance is defined in equation (7).

This measure provides information on the strange and frequency of local design modifications based on the whole data set. The overall displacement variance can be reformulated as shown in equation (8).

The later formulation will reduce computational costs especially in case when many vertices built up the surface mesh and the overall displacement variance measure has to be calculated many times.

Sensitivity Analysis

In aerodynamic design optimization one or more performance values are assigned to the design which describe some special characteristics of the flow surrounding the design. The RMVD and the overall displacement variance only captures information on local design modifications and doesn't take the performance of a design into account. Extracting meaningful information on the interrelation of design modifications and performance changes is quite helpful for developing new outperforming designs.

1) Relative Vertex Correlation Coefficient:

The relative vertex correlation coefficient (RVCC) as formalized in equation (9) calculates the linear interrelation between the local modifications in form of vertex displacement and the performance values, where $\phi^{r,m} = f^r - f^m$ is the performance difference between two designs r and m, see equations (9) to (11).

The RVCC calculates the linear interrelation based on a reference design r. Given the reference design a positive RVCC value for vertex i indicates that moving the vertex towards the direction of the normal vector is most likely to improve the performance of the design and vice versa. An RVCC value Rr i_0 can result form two different situations.

The most obvious situation is that a modification of the vertex has no effect on the performance measure. But if the vertex is located in an optimal position (every modification will always result in a worsening, or every modification will always result in an improved performance value) the RVCC value will also be close to zero and indicates no relation between vertex displacement and performance.

In order to distinguish between both cases one can think of fitting a linear model to the displacement- and performance difference- pairs and can calculate the residual to the fitted linear model. This residual provides information on the uncertainty of the correlation coefficient. The uncertainty of the correlation coefficient might also come from noisy data or non-linear relations between displacement measure and performance differences.

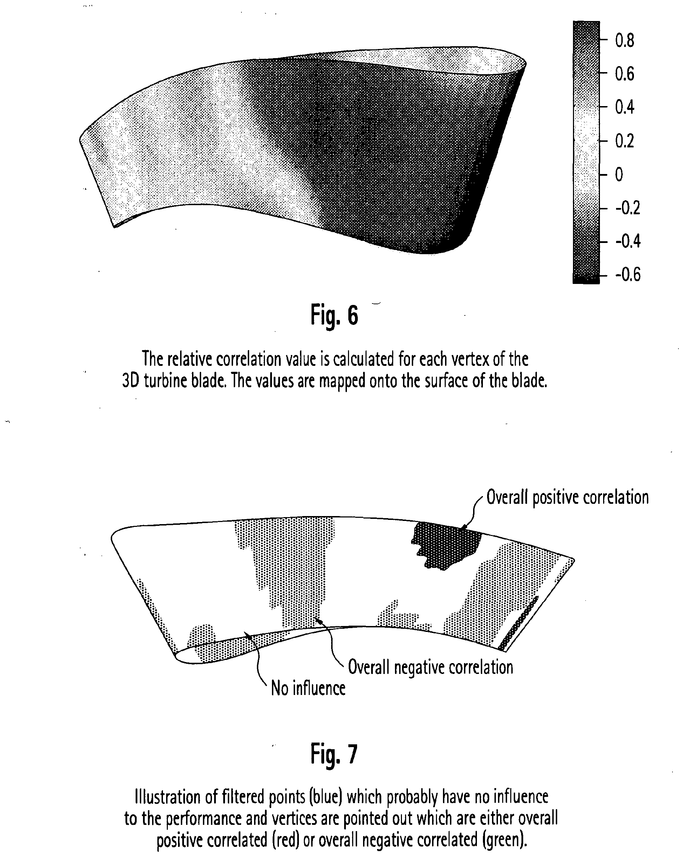

The result can be seen in Fig. 6. Dark codes negative RVCC values. That means that a displacement of dark vertices towards their normal vectors is most likely to worsen the performance measure. And vice versa, red coloured vertices have a positive RVCC value and hence a movement into the direction of the normal vector will probably improve the performance of the design. Without any direction information which is captured by the displacement measure those conclusions can not be drawn.

2) Vertex Sensitivity:

In order to identify vertices which are sensitive to performance changes based on the whole data set without referring one reference design the correlation coefficient is calculated based on all pair-wise design comparisons. Given $N(N-1)$ displacement values for each vertex and $N(N-1)$ performance differences the overall vertex correlation coefficient is defined as shown in equations (12) to (14).

The overall vertex correlation coefficient captures the linear relationship between the displacement and performance changes. Again one can use the Spearman rank correlation coefficient instead of the Pearson correlation coefficient to become less sensitive to outliers and noise in the data.

In aerodynamic design optimization the interrelation between design modifications and performance changes is often highly non-linear. In order to capture also nonlinearities one can use information based measures like mutual information to determine the sensitivity of vertices.

Applying a threshold or some statistical test to the calculated similarity measure like mutual information, Spearman or Pearson correlation coefficient allows to filter vertices which have probably no influence to the performance of the design. The filter process points out most sensitive vertices and also leads to a reduction of the number of parameters for describing the most important design modifications.

For our turbine blade example the overall Pearson correlation coefficient is calculated to determine the sensitivity of each vertex. A threshold is applied to the correlation coefficient based on the suggestions of Cohen. He gave a fuzzy interpretation of the correlation coefficient in J. Cohen, Statistical Power Analysis for the Behavioral Sciences (2nd ed.), Hillsdale, NJ: Lawrence Erlbaum Associates, 1988.

All vertices where the absolute value of the correlation coefficient is below 0.3 have been filtered out. The remaining vertices are identified as sensitive ones which are either overall positive correlated or negative correlated with the performance, see Fig. 7. Using mutual information instead of the Pearson or Spearman correlation coefficient one isn't able to distinguish between positive and negative correlations.

D. Decision Trees and Rule Induction

When calculating the relative vertex correlation coefficient or performing sensitivity analysis the displacement of each vertex is considered independent of the others. Interrelations between vertices or design regions haven't been considered yet. But in aerodynamics the interrelation between locally separated vertices or regions and his influence to the performance plays an important role. Facing that problem the displacement of the vertices can be used as input for several techniques like rule induction, Bayesian networks or decision trees. Such modelling techniques are able to capture the interrelation between different inputs.

If independent of the used technique the number of input parameters is to high the extraction of meaningful and human readable rules becomes much more complicated. That's why sensitivity analysis as described above and the performing of further steps is absolutely advisable. One way to further reduce the number of parameters is to cluster vertices at the surface of the mesh to form sensitive regions. The displacement of the vertices closest to the cluster centers are then used to extract rules, generate decision trees or compute some other models. For the modelling process one can use real valued inputs which capture the sign and the amount of displacement as well as binary inputs which capture just the sign of the displacement measure. What kind of input to choose depends on the information one is interested in.

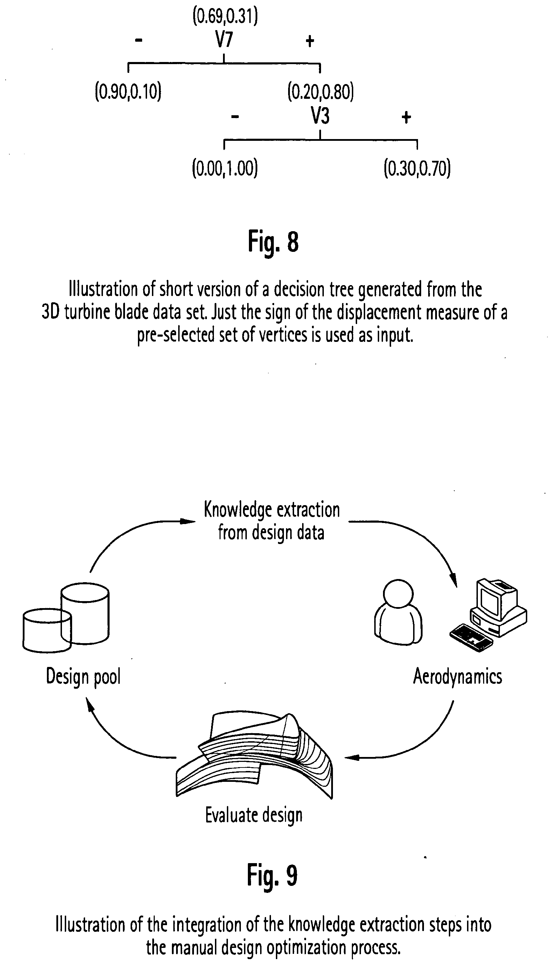

Fig. 8 shows just an short version of a generated decision tree. After sensitivity analysis a probabilistic based clustering has been performed and the sign of the displacement measure of the vertices close to the cluster centers have been used as input for the demission tree. The tree shows the interrelation between vertex V 7 and vertex V 3 and its joint influence to the performance measure.

The short decision tree can be interpreted as follows. Without displacing any vertex the probability of improving the performance is $p = 0.31$ and for getting worse $p = 0.69$.

But when moving vertex 7 (V7) in normal direction (+) and V3 against the normal direction results in a probability of $p = 1.00$ for improving fitness based on the data set at hand.

USE OF THE GAINED INFORMATION AS AN INPUT SIGNAL FOR THE AERODYNAMIC DESIGN OPTIMIZATION PROCESS

In this section it is described how the knowledge retrieved from the suggested formulas and techniques can be used in order to control the design optimization process.

A. Manual Design Optimization Process

In a manual aerodynamic design optimization process the driving force and the source for innovation is the designer or aerodynamics himself. Nowadays often advanced CAD tools are used by the aerodynamics to create and modify the shape of the design. Mostly it's up to the expertise of the aerodynamics to create new outperforming designs. In general wind tunnels, high fidelity simulations or others are used to determine the performance of the design, what is often highly time consuming. Providing the aerodynamics with meaningful knowledge about the objective function helps to reduce the number of performance evaluations and hence saves valuable time for further optimizations.

Most CAD applications are able to generate triangular surface meshes from the constructed designs what in general makes CAD-data usable for the suggested analysis. That most CAD applications can export surface meshes originates from the fact that unstructured triangular surface meshes in STL (stereo-lithography and later standard triangulation language) format are used for the rapid prototyping process. The mesh quality is therefore often tuned to rapid prototyping and doesn't fit well for data analysis, what then needs further post-processing steps.

Fig. 9 illustrates the circular process after integrating knowledge extraction techniques into the manual optimization process. The design data pool consists of all designs and the corresponding performance values which have been designed and evaluated. One pivot design for calculating the corresponding points has to be determined in advance before calculating the displacement values.

The exploration of modifications within the design data set helps the designer to focus on the investigation of design regions which have not been changed so far. Applying sensitivity analysis to the design data set allows to remove local regions from optimization which to certain probability have no influence to the performance measure or to add sensitive regions to the focus of optimization which seem to have an strong influence to the performance. Furthermore knowing about the interrelation between different design regions and their joint influence to the performance measure provides knowledge for estimating the quality of the design in advance. Adding these steps into the manual design optimization process probably will save evaluation time and speed up the optimization process.

B. Computational Design Optimization Process

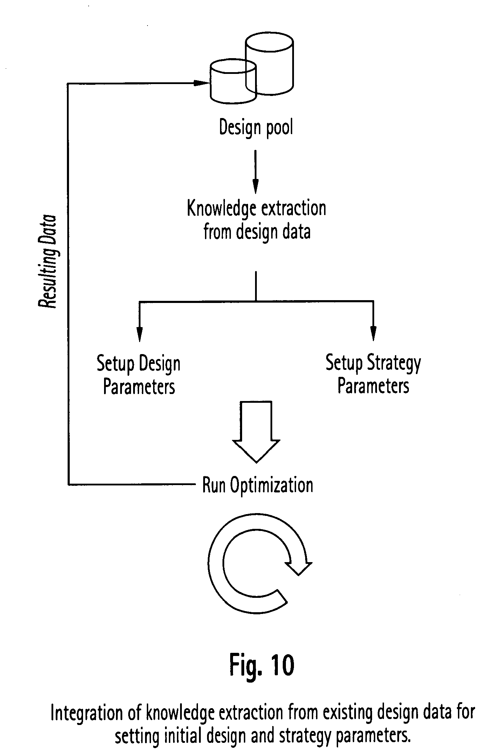

In recent years more and more computer-assisted optimization techniques are applied for aerodynamic design optimization. The list of different optimization algorithms is quite long, e.g. gradient descent, linear programming, Newton's method, simulated annealing, evolution strategies and many more. All have in common that one has to define a set of objective parameters (e.g. spline control points, length, width or others) which are under control of the optimization technique and one or more performance values which describe the performance of each solution (design). Beside the design parameters probably all optimization techniques use a set of strategy parameters (e.g. step sizes) for guiding the optimization towards one or more optimal solution. The strategy parameters are used for the generation of new solutions and might also be under control of the optimization algorithm. Dependent on the optimization technique which is used the convergence of the algorithm is more or less sensitive to the initial setup of the design and/or strategy parameters. Fig. 10 gives an overview on how to integrate knowledge extraction from existing design data for specifying the initial setup of the design and strategy parameters.

Given an existing data set from previous manual or computational optimization runs the sensitivity analysis highlights design regions or vertices which are sensitive to the performance measure. Knowing about the sensitivities the objective parameters can be set in a way that they have the most influence on these regions or vertices. Fig. 7 shows the extracted sensitive regions of the blade design. In case of using spline based representations the control points can be positioned directly close to the most sensitive points. Concerning the blade example the control points would be positioned close to the center of the clusters of the extracted sensitive regions. When then the control points are modified during the optimization the control points have its largest influence arround these sensitive vertices or regions. Using direct manipulation, the vertices from the unstructured surface mesh representation can directly be used as parameters for optimization. For some details please refer to Stefan Menzel, Markus Olhofer, Bernhard Sendhoff, "Direct Manipulation of Free Form Deformation in Evolutionary Design Optimisation" in proceedings of the International Conference on Parallel Problem Solving From Nature (PPSN), edited by T.P. Runarsson et al., Springer-Verlag, page 352-361 in 2006.

The efficient setup of the design parameters should also depend on the analysis of design modifications. The optimization parameters should also influence regions of the design which haven't been changed so far. For example position control points around regions where the overall variance of the displacement measure is zero. This allows the exploration of new design concepts. Furthermore this will add new information to the database.

One way to speed up the evolutionary project is to reduce the number of parameters which should be optimized. When rules can be extracted which point out a close interrelation between sensitive regions or vertices those regions or vertices can be optimized together. That means that just one of both vertices is optimized and the remaining one is modified with respect to the optimized one.

The above steps allow to setup the most relevant parameters for the optimization. In general the initial strategy parameters like step sizes are set by random. Setting up the strategy parameters with information from the database allow to give the optimization algortihm a preferred direction. Doing so, the optimization algorithm saves time for adapting the strategy parameters and thus earlier starts to converge to an optimal solution. To setup the strategy parameters information from the sensitivity analysis can be used. How this information can be encoded into the strategy parameters strongly depends on the choice of the objective parameters. Assume the position (x,y,z) of a sensitive vertex is encoded and a start design is provided. One can calculate the relative vertex correlation coefficient with respect to the start design. The sign of the relative vertex correlation coefficient indicates the direction of modification which is more likely to improve the performance. If the strategy parameters encode step sizes for the coordinates of the sensitive vertices the sign of the relative vertex correlation coefficient has to be coded into the sign for the step sizes for x, y and z. While the initial value for the step size can be set with respect to the amount of the relative vertex correlation coefficient.

After setting design and strategy parameters and starting the optimization algorithm all generated results can be stored within the database where they are available for further analysis.

C. Surrogate Model

In computational design optimization often high fidelity simulations are applied for evaluating the performance of one design. Such simulations (e.g. computational fluid dynamics (CFD) simulations) which try to imitate real physical conditions are often highly time-consuming. Recently approximation models like polynomials, kriging model, feedforward neural networks or others are used to partially substitute time consuming fitness evaluations. These models are also named surrogate models or meta models. The evaluation time is quite low compared to high-fidelity simulations but the models are able to capture only a subset of the real performance landscape and therefore the surrogate models can not completely replace the original fitness evaluation.

In order to get an overview on surrogate models and on substitution strategies the reader is referred to Yaochu Jin, A Comprehensive Survey of Fitness Approximation in Evolutionary Computation, Soft Computing, vol. 9, no. 1, pp. 3-12, 2005.

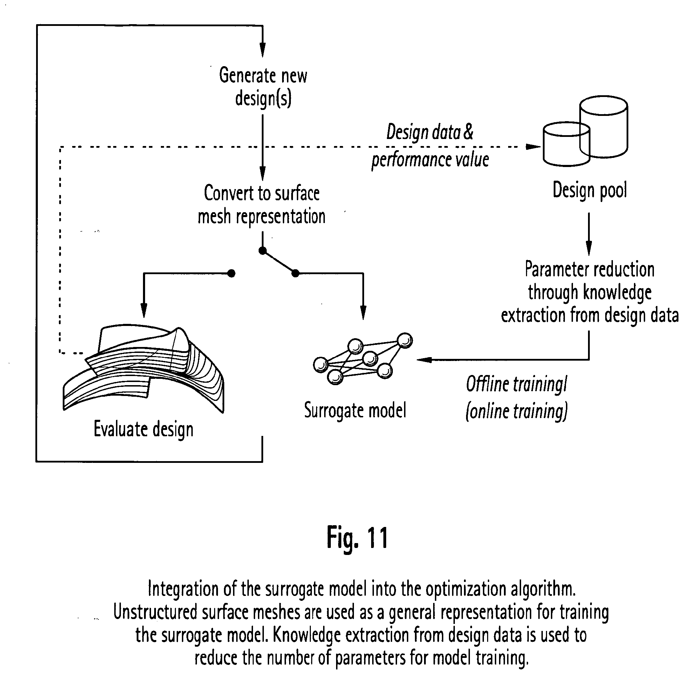

The estimation quality of the surrogate model strongly depends on the data which is used training the model. Sticking to a general design representation like unstructured surface meshes allows to use as most design data as possible for training without being restricted to the choice of the design parameters. Under the assumption that all designs can be converted to the surface mesh representation all existing designs from previous optimization runs can be used for offline training of the model. Designs which are generated during the actual optimization run can be used to update the trained model or to train a new model and built up and ensemble of approximation models for the estimation of the performance of the designs. Fig. 11 gives an overview on the complete process.

Because the number of parameters of an triangular surface mesh is in nearly all cases much to high in order to train an approximation model in a reasonable way, it is suggested to use knowledge extraction techniques to reduce the number of parameters before offline training of the model. This can be done in the following steps:

1) Determine sensitivity of each vertex
2) Apply threshold for neglecting insensitive vertices
3) Cluster sensitive vertices to form sensitive regions
4) Determine cluster-centers of sensitive regions
5) Take displacement of cluster-centers with respect to a pivot design together with the performance values as training data for the approximation model
6) For the estimation of the performance of a new generated design during the optimization apply the displacement of the cluster-centers on the pivot design to the corresponding cluster centers on the new design

Equations:

$$\delta_{i,j}^{l,m} = \delta(\vec{v}_i^l, \vec{v}_j^m) = (\vec{v}_i^l - \vec{v}_j^m) \circ \vec{n}_i^l, \delta \in (-\infty, +\infty) \quad (1)$$

$$\delta_{i,j}^{l,m} = (\vec{s}_{ij} + \vec{e}_{ij}) \circ \vec{n}_i^l \quad (2)$$

$$\delta_{i,j}^{l,m} = \vec{s}_{ij} \circ \vec{n}_i^l + \vec{e}_{ij} \circ \vec{n}_i^l \quad (3)$$

$$\vec{e}_{ij} \circ \vec{n}_i^l \approx |\vec{e}_{ij}| cos(\angle(\vec{e}_{ij}, \vec{n}_j^m)). \quad (4)$$

$$\overline{\delta}_i^r = \frac{1}{N-1} \sum_{m=1, m \neq r}^{N} \delta_{i,j}^{r,m} \qquad (5)$$

$$\overline{\delta}_i = \frac{1}{N(N-1)} \sum_{l=1}^{N} \sum_{m=1, m \neq l}^{N} \delta_{i,j}^{l,m} \approx 0 \qquad (6)$$

$$\sigma_{\delta_i} = \sqrt{\sum_{l=1}^{N} \sum_{m=1, m \neq l}^{N} (\delta_{i,j}^{l,m} - \overline{\delta}_i)^2} \qquad (7)$$

$$\sigma_{\delta_i} \approx \sqrt{2 \cdot \sum_{l=1}^{N} \sum_{m=l+1}^{N} (\delta_{i,j}^{l,m})^2} \qquad (8)$$

$$R_i^r = \frac{\sum_{m=1, m \neq r}^{N} (\delta_{i,j}^{r,m} - \overline{\delta}_i^r)(\phi^{r,m} - \overline{\phi}^r)}{\sigma_{\delta_i^r} \sigma_{\phi^r}} \qquad (9)$$

$$\sigma_{\delta_i^r} = \sqrt{\sum_{m=1, m \neq r}^{N} (\delta_{i,j}^{r,m} - \overline{\delta}_i^r)^2} \qquad (10)$$

$$\overline{\phi}^r = \frac{1}{N} \sum_{m=1, m \neq r}^{N} \phi^{r,m} \qquad (11)$$

$$R_i = \frac{\sum_{l=1}^{N} \sum_{m=1, m \neq l}^{N} (\delta_{i,j}^{l,m} - \overline{\delta}_i) \phi^{l,m}}{\sigma_{\delta_i} \sigma_{\phi}} \qquad (12)$$

$$\overline{\phi} = \frac{1}{N(N-1)} \sum_{l=1}^{N} \sum_{m=1, m \neq l}^{N} \phi^{l,m} = 0 \qquad (13)$$

$$\sigma_\phi = \sqrt{\sum_{l=1}^{N} \sum_{m=1, m \neq l}^{N} (\phi^{l,m})^2} \qquad (14)$$

**Claims**

1. A computer-implemented method for optimizing a turbine blade based on analysing design data representing the optimization of the turbine blade as a 3D aerodynamic design according to at least one physical criterion indicating a location dependent aerodynamic drag, aerodynamic lift or pressure loss, wherein

   - the design data representing modifications of the 3D aerodynamic design are provided, wherein the design data are represented by unstructured triangular surface meshes,
   - a displacement measure representing the local differences between two modifications of the 3D aerodynamic design is calculated based on the unstructured triangular surface meshes representing the design data,
   - an aerodynamic performance difference of the location dependent aerodynamic drag, aerodynamic lift or pressure loss, expressed by the at least one physical criterion, between the two design modifications is calculated,
   - a sensitivity information is generated representing the interrelation between the displacement measure and the performance difference, and
   - the sensitivity information is output indicating a location dependent aerodynamic performance sensitivity to changes in the modifications of the analysed design data,
   - setting initial design parameters for an initial 3D aerodynamic design depending on the output sensitivity information,
   - running an optimization algorithm starting from the initial 3D aerodynamic design until a stop criterion has been reached to generate an optimized 3D aerodynamic design,

   wherein strategy parameters of the optimization algorithm are set based on the output sensitivity information, and

   - outputting design data representing the optimized 3D aerodynamic design.

2. The method according to claim 1,
   wherein a linear or non-linear interrelation is represented by the output sensitivity information.

3. The method according to claim 1 or 2,
   wherein the output sensitivity information is a correlation coefficient or a mutual information.

4. The method according to any of the preceding claims,
   wherein the output sensitivity information indicates which regions of the 3D aerodynamic design influence the aerodynamic performance when changed.

5. The method according to claim 4,
   wherein interrelations between design regions are calculated by means of rule induction from decision trees.

6. The method according to any of claims 1 to 5,
   wherein the optimization algorithm is an evolutionary optimization, starting from the initial 3D aerodynamic design until the stop criterion has been reached.

7. The method according to any of claims 1 to 6,
   wherein the position of spline control points is set depending on the sensitivity information.

8. The method according to any of claims 1 or 7,
   wherein the strategy parameters include a global or individual step size set depending on the sensitivity information.

**EP 2 012 243 B1**

9. A computer-implemented method for generating a meta model, such as e.g. a neural network, for computing, in terms of physical entities the fitness of design data representing 3D aerodynamic designs,
the method comprising the steps of:

- generating a sensitivity information signal by using a method according to any of claims 1 to 8,
- setting up the meta model as unstructured surface meshes, and
- adapting a number of parameters for training the meta model using the sensitivity information.

10. A computer program product, implementing a method according to any of the preceding claims when run on a computing device.

**Patentansprüche**

1. Computerimplementiertes Verfahren zum Optimieren einer Turbinenschaufel, basierend auf einer Analyse von Designdaten, die die Optimierung der Turbinenschaufel als 3D aerodynamisches Design repräsentieren, in Bezug auf wenigstens ein physikalisches Kriterium, das einen ortsabhängigen aerodynamischen Widerstand, aerodynamischen Auftrieb oder Druckverlust anzeigt,
wobei

- die Designdatenbank, die die Modifikationen des aerodynamischen 3D Designs repräsentieren, zur Verfügung gestellt werden, wobei die Designdaten durch unstrukturierte Dreiecks-Oberflächennetze repräsentiert werden,
- ein Verschiebungsmaß, das die lokalen Unterschiede zwischen zwei Modifikationen des aerodynamischen 3D Designs angibt, basierend auf den unstrukturierten Dreieck-Oberflächennetzen, die die Designdaten repräsentieren, berechnet wird,
- ein aerodynamischer Leistungsunterschied des ortsabhängigen aerodynamischen Widerstands, aerodynamischen Auftriebs oder Druckverlusts, ausgedrückt durch das wenigstens eine physikalische Kriterium, zwischen den zwei Designmodifikationen berechnet wird,
- eine Empfindlichkeitsinformation erzeugt wird, welche die Wechselbeziehung zwischen dem Verschiebungsmaß und dem Leistungsunterschied repräsentiert, und
- die Empfindlichkeitsinformation, die eine ortsabhängige Empfindlichkeit der aerodynamischen Leistung bezüglich Änderungen in den Modifikationen der analysierten Designdaten angibt, ausgegeben wird,
- Einstellen von ursprünglichen Designparametern für ein ursprüngliches aerodynamisches 3D Design, abhängig von der ausgegebenen Empfindlichkeitsinformation,
- Ausführen eines Optimierungsalgorithmus, beginnend mit dem ursprünglichen aerodynamischen 3D Design, bis ein Stoppkriterium erreicht ist, um ein optimiertes aerodynamisches 3D Design zu erzeugen,

wobei Strategieparameter des Optimierungsalgorithmus basierend auf der ausgegebenen Empfindlichkeitsinformation eingestellt werden, und

- Ausgeben von Designdaten, die das optimierte aerodynamische 3D Design repräsentieren.

2. Verfahren gemäß Anspruch 1,
wobei eine lineare oder nichtlineare Wechselbeziehung durch die ausgegebene Empfindlichkeitsinformation repräsentiert wird.

3. Verfahren gemäß Anspruch 1 oder 2,
wobei die ausgegebene Empfindlichkeitsinformation ein Korrelationskoeffizient oder eine wechselseitige Information ist.

4. Verfahren gemäß einem der vorangegangenen Ansprüche,
wobei die ausgegebene Empfindlichkeitsinformation angibt, welche Bereiche des aerodynamischen 3D Designs die aerodynamische Leistung beeinflussen, wenn sie geändert werden.

5. Verfahren gemäß Anspruch 4,
wobei die Wechselbeziehungen zwischen Designbereichen mittels Regelinduktion aus Entscheidungsbäumen berechnet werden.

**6.** Verfahren gemäß einem der Ansprüche 1 bis 5,
wobei der Optimierungsalgorithmus eine evolutionäre Optimierung ist, beginnend mit dem ursprünglichen aerodynamischen 3D Design, bis ein Stoppkriterium erreicht wurde.

**7.** Verfahren nach einem der Ansprüche 1 bis 6,
wobei die Position der Kurven-Steuerungspunkte abhängig von der Empfindlichkeitsinformation gesetzt wird.

**8.** Verfahren gemäß einem der Ansprüche 1 oder 7,
wobei die Strategieparameter eine globale oder individuelle Schrittgröße aufweisen, die abhängig von der Empfindlichkeitsinformation eingestellt wird.

**9.** Computerimplementiertes Verfahren zum Erzeugen eines Metamodells, wie zum Beispiel eines neuronalen Netzes, zum Berechnen, bezüglich physikalischer Einheiten, der Fitness von Designdaten, die aerodynamische 3D Designdaten repräsentieren, wobei das Verfahren die Schritte umfasst:

- Erzeugen eines Empfindlichkeitsinformationssignals durch Verwenden eines Verfahrens gemäß einem der Ansprüche 1 bis 8,
- Aufbauen des Metamodells als unstrukturiertes Oberflächennetz, und
- Anpassen einer Anzahl von Parametern zum Trainieren des Metamodells, verwendend die Empfindlichkeitsinformation.

**10.** Computerprogrammprodukt, umsetzend ein Verfahren gemäß einem der vorangegangenen Ansprüche, wenn es auf einer Computervorrichtung ausgeführt wird.

**Revendications**

**1.** Procédé mis en oeuvre par ordinateur pour optimiser une pale de turbine d'après l'analyse de données de conception représentant l'optimisation de la pale de turbine sous forme de conception aérodynamique 3D selon au moins un critère physique indiquant une traînée aérodynamique, une portance aérodynamique ou une perte de pression dépendant de l'emplacement,
dans lequel

- les données de conception représentant des modifications de la conception aérodynamique 3D sont fournies, dans lequel les données de conception sont représentées par des mailles de surface triangulaires non structurées,
- une mesure de déplacement représentant les différences locales entre deux modifications de la conception aérodynamique 3D est calculée d'après les mailles de surface triangulaires non structurées représentant les données de conception,
- une différence de performance aérodynamique de la traînée aérodynamique, de la portance aérodynamique ou de la perte de pression dépendant de l'emplacement, exprimée par l'au moins un critère physique, entre les deux modifications de conception est calculée,
- une information de sensibilité est générée représentant l'interrelation entre la mesure de déplacement et la différence de performance, et
- l'information de sensibilité est délivrée indiquant une sensibilité de performance aérodynamique dépendant de l'emplacement à des changements des modifications des données de conception analysées,
- le réglage de paramètres de conception initiaux pour une conception aérodynamique 3D initiale selon l'information de sensibilité délivrée,
- l'exécution d'un algorithme d'optimisation en partant de la conception aérodynamique 3D initiale jusqu'à ce qu'un critère d'arrêt ait été atteint pour générer une conception aérodynamique 3D optimisée,

dans lequel des paramètres de stratégie de l'algorithme d'optimisation sont réglés d'après l'information de sensibilité délivrée, et

- la fourniture en sortie de données de conception représentant la conception aérodynamique 3D optimisée.

**2.** Procédé selon la revendication 1,
dans lequel une interrelation linéaire ou non linéaire est représentée par l'information de sensibilité délivrée.

**3.** Procédé selon la revendication 1 ou 2,
dans lequel l'information de sensibilité délivrée est un coefficient de corrélation ou une information mutuelle.

**4.** Procédé selon l'une quelconque des revendications précédentes,
dans lequel l'information de sensibilité délivrée indique quelles régions de la conception aérodynamique 3D influencent la performance aérodynamique lorsqu'elles sont changées.

**5.** Procédé selon la revendication 4,
dans lequel des interrelations entre des régions de conception sont calculées au moyen d'une induction de règle à partir d'arbres de décision.

**6.** Procédé selon l'une quelconque des revendications 1 à 5,
dans lequel l'algorithme d'optimisation est une optimisation évolutive, en partant de la conception aérodynamique 3D initiale jusqu'à ce que le critère d'arrêt ait été atteint.

**7.** Procédé selon l'une quelconque des revendications 1 à 6,
dans lequel la position de points de commande de spline est réglée selon l'information de sensibilité.

**8.** Procédé selon l'une quelconque des revendications 1 ou 7,
dans lequel les paramètres de stratégie comportent une taille de pas globale ou individuelle selon l'information de sensibilité.

**9.** Procédé mis en oeuvre par ordinateur pour générer un méta modèle, tel que par exemple, un réseau neuronal, pour calculer, en termes d'entités physiques l'aptitude de données de conception représentant des conceptions aérodynamiques 3D,
le procédé comprenant les étapes de :

- génération d'un signal d'information de sensibilité en utilisant un procédé selon l'une quelconque des revendications 1 à 8,
- mise en place du méta modèle en tant que mailles de surface non structurées, et
- adaptation d'un nombre de paramètres pour l'apprentissage du méta modèle à l'aide de l'information de sensibilité.

**10.** Produit-programme d'ordinateur, mettant en oeuvre un procédé selon l'une quelconque des revendications précédentes lorsqu'il est exécuté sur un dispositif informatique.

$$V = (v_1, v_2, v_3)$$

$$N = (n_1, n_2, n_3)$$

$$K = \{\{1, 2, 3\}....\}$$

Face $\{1, 2, 3\}$

# Fig. 1

Illustration of a triangular surface mesh $\mathcal{M} : (V, N, \mathcal{K})$ defined
by a list of vertices $V$, normal vectors $N$ and a complex $\mathcal{K}$ defining all
triangular faces.

a)

$\delta(\vec{v}_i^l, \vec{v}_j^m) > 0$

b)

$\delta(\vec{v}_i^l, \vec{v}_j^m) < 0$

c)

$\delta(\vec{v}_i^l, \vec{v}_j^m) = 0$

d)

$\delta(\vec{v}_i^l, \vec{v}_j^m) = 0$

## Fig. 2

Case study for the displacement measure. a) and b) should illustrate
that vertex displacement in (against) normal direction results in positive
(negative) displacement value. A displacement perpendicular to the normal
vector results in a displacement value of zero, as shown in c) and d).

## Fig. 3

Illustration of the error vector $\vec{e}_{ij}$ as the difference between the correct
difference vector $\vec{s}'_{ij}$ and the difference vector between corresponding vertices $\vec{s}_{ij}$.

## Fig. 4

Illustration of a triangular mesh defining the surface of a 3D turbine blade.

| 0.5 |
| 0 |
| -0.5 |
| -1 |
| -1.5 |
| -2 |
| -2.5 |
| -3 |

## Fig. 5

The mean value of a set of turbine blades is calculated for each
vertex with respect to one design and mapped onto the surface of the
reference blade.

0.8
0.6
0.4
0.2
0
-0.2
-0.4
-0.6

## Fig. 6

The relative correlation value is calculated for each vertex of the
3D turbine blade. The values are mapped onto the surface of the blade.

Overall positive correlation

Overall negative correlation

No influence

## Fig. 7

Illustration of filtered points (blue) which probably have no influence
to the performance and vertices are pointed out which are either overall
positive correlated (red) or overall negative correlated (green).

**Fig. 8**

Illustration of short version of a decision tree generated from the
3D turbine blade data set. Just the sign of the displacement measure of a
pre-selected set of vertices is used as input.

**Fig. 9**

Illustration of the integration of the knowledge extraction steps into
the manual design optimization process.

## Fig. 10

Integration of knowledge extraction from existing design data for setting initial design and strategy parameters.

# Fig. 11

Integration of the surrogate model into the optimization algorithm.
Unstructured surface meshes are used as a general representation for training
the surrogate model. Knowledge extraction from design data is used to
reduce the number of parameters for model training.

Design
Database

Calculate performance
differences between designs

Measure local differences
between designs by means of
calculating the displacement
value between pairs of corres-
ponding vertices, see
equation (1).

Identify sensitive vertices or
design regions, see section C.

Analyze the interrelation between
sensitive regions or vertices and
their joint influence to the performance
of the designs, see section D.

Analyze design modifications
by calculating RMVD and/or
the overall displacement variance,
see dection B.

Knowledge pool
(e.g. information on design
modifications or sensitive
vertices)

Fig. 12

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1486893 A2

- US 20050159936 A1

**Non-patent literature cited in the description**

- **MARC ALEXA.** *Recent Advances in Mesh Morphing, Computer Graphics forum,* 2002, vol. 21 (2), 173-197
- **J. COHEN.** Statistical Power Analysis for the Behavioral Sciences. Lawrence Erlbaum Associates, 1988

- Direct Manipulation of Free Form Deformation in Evolutionary Design Optimisation. **STEFAN MENZEL ; MARKUS OLHOFER ; BERNHARD SENDHOFF et al.** proceedings of the International Conference on Parallel Problem Solving From Nature (PPSN). Springer-Verlag, 2006, 352-361
- **YAOCHU JIN.** *A Comprehensive Survey of Fitness Approximation in Evolutionary Computation, Soft Computing,* 2005, vol. 9 (1), 3-12